Europäisches Patentamt

European Patent Office

Office européen des brevets

(11) Veröffentlichungsnummer: **0 427 081 A2**

# EUROPÄISCHE PATENTANMELDUNG

(21) Anmeldenummer: **90120689.6**

(22) Anmeldetag: **29.10.90**

(51) Int. Cl.⁵: **H05K 3/00, B23Q 3/10**

(30) Priorität: **04.11.89 DE 3936723**

(43) Veröffentlichungstag der Anmeldung:
**15.05.91 Patentblatt 91/20**

(84) Benannte Vertragsstaaten:
**AT BE CH DE FR GB IT LI LU NL SE**

(71) Anmelder: **Löhr & Herrmann GmbH**
**Hesselbachstrasse 15**
**W-7531 Neuhausen(DE)**

(72) Erfinder: **Löhr, Hans-Günter, Dr.-Ing.**
**Ahornweg 3**
**W-7135 Wiernsheim(DE)**

Erfinder: **Herrmann, Gunter, Dr.-Ing.**
**Hindenburgstrasse 21**
**W-7260 Calw(DE)**
Erfinder: **Rothen, Markus**
**Dornackerweg 16b**
**CH-4950 Huttwil(CH)**

(74) Vertreter: **Hubbuch, Helmut, Dipl.-Ing et al**
**Patentanwälte Dr. Rudolf Bauer Dipl.-Ing.**
**Helmut Hubbuch Dipl.-Phys. Ulrich**
**Twelmeier Westliche Karl-Friedrich-Strasse**
**29-31**
**W-7530 Pforzheim(DE)**

(54) **Vorrichtung zum selbsttätigen Positionieren von Leiterplatten.**

(57) Die Erfindung betrifft eine Vorrichtung zum selbsttätigen Positionieren von Leiterplatten, was geschieht durch die Verwendung von paarweise angeordneten, analog, insbesondere induktiv arbeitenden Sensoren, welche mit Positionierungsmarken auf der Leiterplatte zusammenarbeiten, wobei ungleich große elektrische Signale der zusammengehörigen Sensorpaare erzeugt werden, deren Differenz proportional zu der Positionsabweichung ist und zur Ansteuerung eines jeweils zugehörigenstellmotors dienen, mit dem die Positionsabweichung der Leiterplatte, insbesondere über deren Auflage korrigiert wird, wobei das Ausgangssignal der Sensoren jeweils proportional zum Anteil der von den Positionierungsmarken abgedeckten Sensorfläche ist.

Fig 4

## VORRICHTUNG ZUM SELBSTTÄTIGEN POSITIONIEREN VON LEITERPLATTEN

Die Erfindung bezieht sich auf eine Vorrichtung zum selbstätigen Positionieren von Leiterplatten zur positionsgerechten Weitergabe oder zur positionsgerechten Einlage an der jeweiligen Bearbeitungsstelle.

Beim Fertigungsprozeß sind Leiterplatten (LP) für verschiedene Bearbeitungsschritte jeweils in einer exakten Lage zu positionieren, so z.B. beim Belichten, Stanzen oder Ritzen. In der Regel geschieht dies, indem die LP mit Referenz- oder Registrierbogen versehen werden, die in Positionierstifte an den Bearbeitungsmaschinen einzubringen sind. Diese mechanische Positionierung der LP hat verschiedene Nachteile, u.a., daß die Automatisierung des Beladens nur mit geringer Zuverlässigkeit möglich ist, insbesondere wenn bei der Bearbeitung Späne anfallen. Ferner ist stets ein gewisses Spiel zwischen Stift und Bohrung erforderlich, um das Ein- und Ausgeben der LP zu ermöglichen.

Um die damit verbundenen Probleme zu verringern, sind auch schon optische Positioniersysteme im Einsatz, bei welchen Zielmarken, die sich auf den LP befinden, mit geeigneten ortsfesten Kameras betrachtet und Abweichungen zwischen der Soll- und Ist-Position auf optoelektronischem Weg festgestellt und in Steuersignale für Motoren umgewandelt werden, mit denen die Position der LP so korrigiert werden, daß die Soll- und Ist-Position innerhalb einer gegebenen Toleranz übereinstimmen.

So zeigt die DE-OS 35 06 279 den Einsatz von sogenannten Diodenkameras für Positionierungszwecke, wobei die aufgenommenen Bilder mittels Computer in Steuersignale umzuwandeln sind. Der Nachteil dieser Lösung liegt in den hohen Kosten, bedingt durch die komplexen Anforderungen an die Beleuchtung und dem hohen Aufwand für die Auswertung des Bildes, worunter auch die Genauigkeit leidet.

Aufgabe der Erfindung ist es demgegenüber eine kostengünstige Lösung zur berührungslosen, selbsttätigen Positionierung von LP mit hoher Genauigkeit zu entwickeln.

Zur Lösung dieser Aufgabe kennzeichnet sich die Vorrichtung zum selbsttätigen Positionieren von Leiterplatten nach dem Oberbegriff gemäß Anspruch 1 der Erfindung dadurch, daß bei analog, insbesondere, induktiv arbeitenden Sensoren Positionsmarken - Kupferflächen - auf den Leiterplatten vorgesehen sind, welche mindestens zwei zur Leiterplatte parallele Absätze oder Kanten besitzen und bei Anordnung der Sensoren im gleichen parallelen Abstand, in welchem sich die beiden parallelen Absätze oder Kanten der Positionsmarken auf den Positionsmarken auf den Leiterplatten befinden, drei Sensorpaare in Verbindung mit je einem Stellmotor zur Positionierung der jeweiligen Leiterplatte in Längs- und Quer- sowie Drehrichtung dienen.

Hierbei dienen bei ungleich großen elektrischen Signalen zusammengehöriger Sensorpaare, deren Differenz proportional zu der Postionsabweichung ist, zur Ansteuerung eines jeweils zugehörigen Stellmotors, mit dem die Positionsab weichung der Leiterplatte zur Korrektur insbesondere über deren Auflage erfolgt. Hierbei ist das Ausgangssignal der Sensoren jeweils proportional zum Anteil der von den Positionierungsmarken abgedecktensensorflächen, hier den Kupferflächen.

Im einzelnen betätigen hierbei zwei Verstellmotore parallele Spindeln je für sich in Längsrichtung und ein dritter Verstellmotor verschiebt die beiden Verstellmotoren gemeinsam in Querrichtung.

Die erfindungsgemäße Vorrichtung zum selbsttätigen Positionieren von Leiterplatten basiert somit auf der Anwendung von berührungslos arbeitenden Sensoren in Verbindung mit geeigneten Positioniermarken auf der LP, Verstärkern und Stellmotoren. Die LP werden mit mehreren Positionier-Markierungen versehen, die an der LP z.B. durch Absätze der Kupferdeckschicht unmittelbar mit dem Leiterbahnbild erzeugt werden können. Die Sensoren besitzen danach eine bestimmte "Aufnahmefläche". Wird ein Teil dieser Aufnahmefläche durch die Positionier-Markierung auf der LP abgedeckt, entsteht ein elektrisches Signal. Dieses elektrische Signal ist analog zu dem Anteil der Aufnahmefläche, der von der Markierung abgedeckt wird. Durch Abfrage mit zwei Sensoren an gegeüberliegenden Kanten der Markierung werden zwei Signale erzeugt, deren Stärke unterschiedlich hoch ist, wenn die Sensoren in unterschiedlichem Maße von der Markierung abgedeckt werden. Stellt man den Abstand der beiden Sensoren exakt auf die Breite der Markierung ein und liegt diese genau symmetrisch zwischen den Sensoren, so ist die Signalstärke beider Sensoren gleich groß. Man kann somit die Differenz der beiden Sensor-Signale als Steuersignal verwenden, mit dem ein Motor angesteuert wird, der die LP so unter den ortsfesten Sensoren verschiebt, bis das Differenzsignal den Wert Null oder einen minimalen Betrag angenommen hat. In diesem Zustand befindet sich die Markierung genau symmetrisch zwischen den beiden Sensoren, also in ihrer optimalen Position. Werden nun drei solcher Markenpaare bei entsprechender Anordnung mit drei Paar Sensoren in dieser Weise abgefragt und deren Lage korrigiert, ist auch die LP insgesamt optimal in der Ebene und zwar in Längs- und Quer- sowie Drehrichtung positioniert.

Weitere Einzelheiten ergeben sich aus den nachfolgenden Erläuterungen der Erfindung in Verbindung mit den Zeichnungen.

Bevorzugte Ausführungsformen der Erfindung sind beispielsweise in der Zeichnung dargestellt und danach beschrieben und zwar zeigen:

Figur 1 eine schematische Darstellung einer Leiterplatte mit zwei Positioniermarken und

Figur 1a den vergrößerten Auschnitt S hierzu,

Figur 2 schematisch die Anordnung der Sensoren an der Positionsmarke entsprechend dem Ausschnitt S,

Figur 3 schematisch eine Anordnung der Stellmotoren zur Korrektur der LP-Position,

Figur 4 schematisch eine weitere Anordnung der Stellmotoren zur Korrektur der LP-Position.

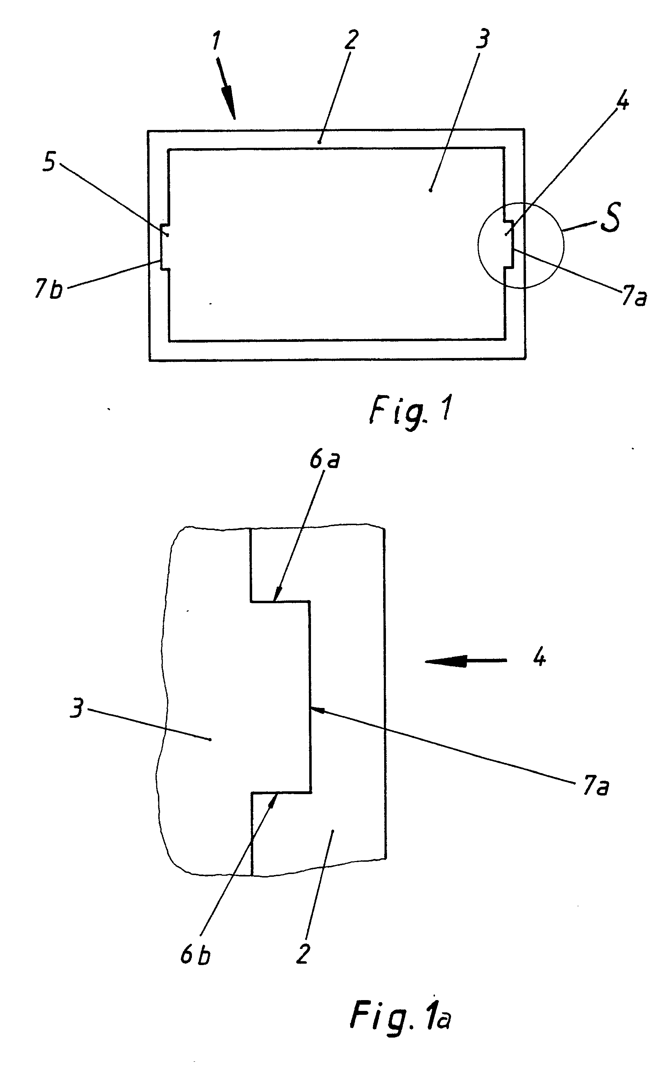

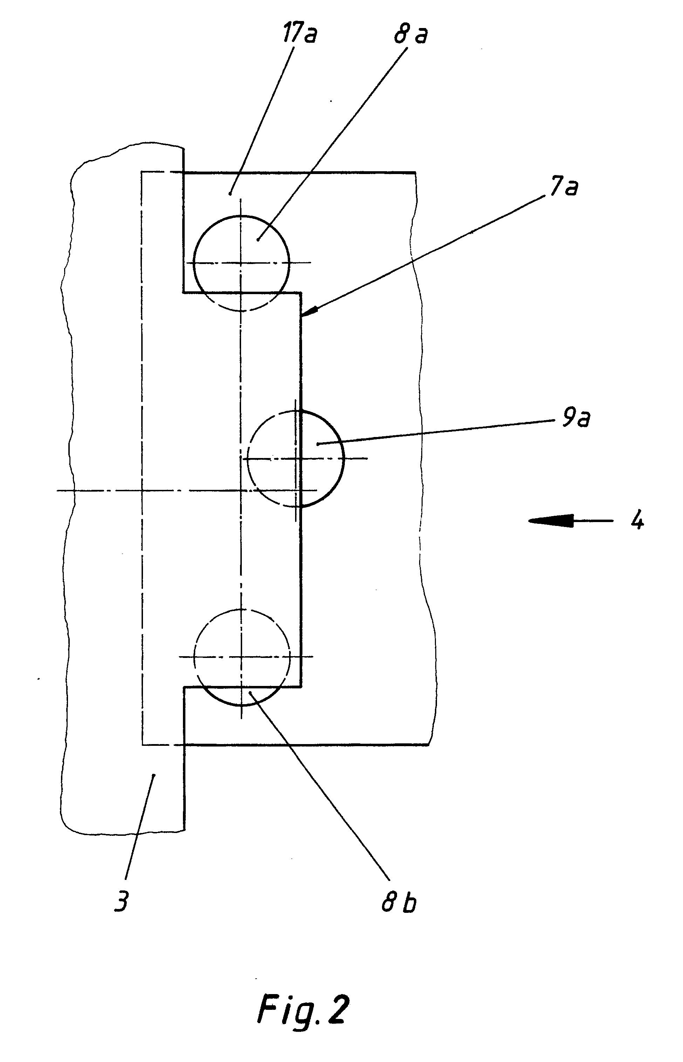

Wie aus den Zeichnungen ersichtlich wird, sind nach Figur 1 und 1a die Positionsmarken 4, 5 an zwei gegenüberliegenden Seiten der Leiterplatte 1 angebracht. Sie sind Teil der Kupfer-Decklage 3 der Leiterplatte 1 und ragen in den Rand 2 der Leiterplatte hinein, auf dem sich kein Kupfer mehr befindet. Jede Positionsmarke weist drei parallel bzw. im rechten Winkel zueinander angeordnete Kanten 6a, 6b und 7a auf. Der Abstand zwischen den Kanten 6a und 6b ist bestimmt und gleich dem Mittenabstand der in Figur 2 schematisch gezeigten Sensoren 8a und 8b; entsprechendes gilt für die einander gegenüberliegenden Kanten 7a und 7b und der Sensoren 9a und 9b.

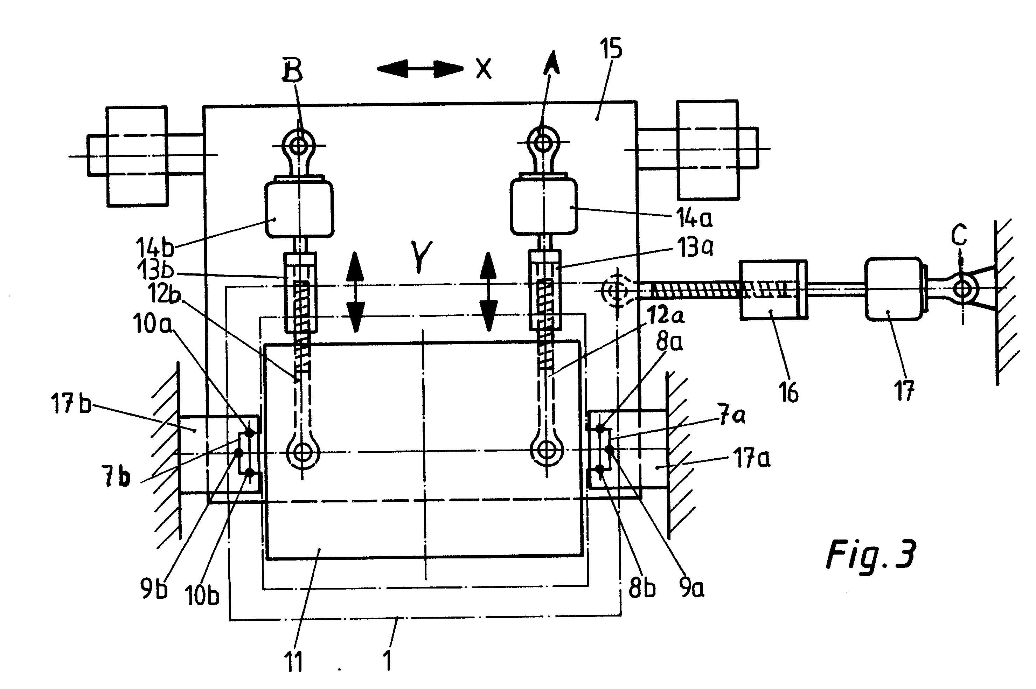

Die Sensoren 8a, 8b und 9a sind in einem ortsfest angebrachten Halter 17a, die Sensoren 9b, 10a und 10b in einem gegenüberliegenden, ebenfalls ortsfesten Halter 17b eingebaut und bestimmen die gewünschte Endlage der in Figur 3 strichpunktiert. angedeuteten Leiterplatte 1 mit den Kanten 7a und 7b u.a..

Diese (1) liegt auf einem Tisch 11 auf, der von zwei Auslegern 12a und 12b gehalten wird, welche (12a, 12b) über je eine Spindel mit Mutter 13a und 13b axial in Richtung "Y" verschiebbar sind. Der Antrieb erfolgt für jeden Ausleger getrennt durch je einen Stellmotor 14a bzw. 14b. Die gesamte Einheit der Motoren 14a und l4b sowie Ausleger 13a und 13b sind bei A und B schwenkbar auf einem Tisch 15 montiert. Der Tisch 15 kann seinerseits in der Richtung "X" mit der Ausleger-Spindelmutter-Motor-Einheit 16, 17 verschoben werden, welche bei C schwenkbar gelagert ist. Wird eine Leiterplatte 1 auf den Tisch 11 aufgelegt, so muß diese mindestens so vorpositioniert sein, daß die Sensoren 8 bis 10 teilweise von den Positionsmarken der Leiterplatte abgedeckt werden. Aufgrund der unterschiedlichen Signale von den zusammengehörigen, einander gegenüber angeordneten Positionsmarken 9a und 9b wird der Stellmotor 17 betätigt, bis das Differenzsignal von den beiden Sensoren 9a und 9b gleich Null geworden ist. In gleicher Weise werden die Motoren 14a und 14b in Abhängigkeit von den Differenzsignalen der Sensoren 8a und 8b bzw. 10a und 10b angesteuert.

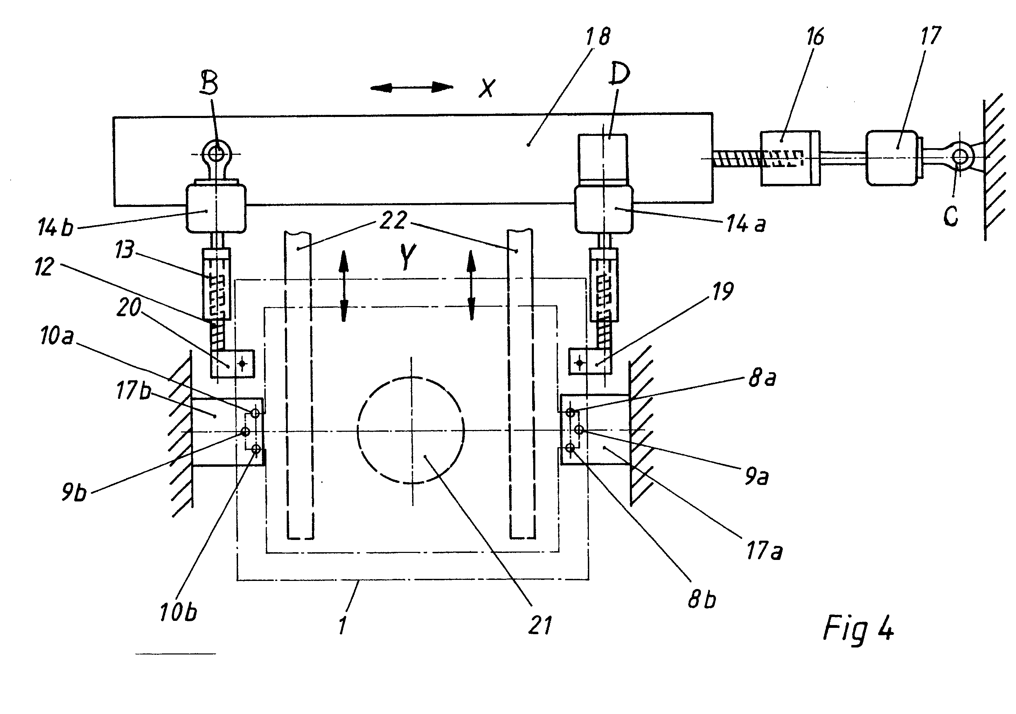

Eine weitere Ausführungsform zeigt Figur 4. Hierbei ist die Anordnung der Sensoren gleich wie bei der in Figur 3 gezeigten Ausführung, jedoch ist die Mechanik der Verstelleinrichtung anders ausgeführt. Statt des Tisches 15 wird ein Verstellbalken 18 verwendet, der mit dem Motor 17 und dem Ausleger 16 verschoben wird und bei C schwenkbar angebracht ist. Auf diesem ist bei D starr der Motor 14a mit dem Ausleger 13 und den Klemmbacken 19 angebracht. Die Klemmbacken 19 greifen am äußeren Rand 2 mit Spitzen an der Leiterplatte 1 an, so daß diese (1) sich während des Positionierens leicht verdrehen läßt. Da der äußere Rand nicht für das Leiterbild benutzt wird, sind kleinere Eindrücke von den Spitzen ohne Bedeutung. Der Ausleger 13 mit dem Motor 14b ist bei B innerhalb eines gewissen Winkels schwenkbar gelagert und besitzt am Ende ebenfalls ein Paar Klemmbacken 20.

Der Transport der LP in die Positioniereinrichtung kann z. B. mit Transportbändern 22 erfolgen. Die Fixierung der positionierten LP für die Bearbeitung ist z.B. mit einem Vakuum-Teller 21 möglich, der sich unterhalb der LP befindet und der anheb- und verschiebbar oder verschwenkbar sein kann.

## Ansprüche

1. Vorrichtung zum selbsttätigen Positionieren von Leiterplatten zur positionsgerechten Weitergabe oder zur positionsgerechten Einlage an der jeweiligen Bearbeitungsstelle unter Verwendung von Zielmarken auf den Leiterplatten, dadurch gekennzeichnet,

daß bei analog, insbesondere induktiv arbeitenden Sensoren, Positionsmarken - Kupferflächen - auf den Leiterplatten vorgesehen sind, welche mindestens zwei zur Leiterplatte parallele Absätze oder Kanten besitzen und bei Anordnung der Sensoren in gleichen Abstand, in welchem sich die beiden parallelen Absätze oder Kanten der Positionsmarken auf den Leiterplatten befinden, drei Sensorpaare in Verbindung mit je einem Stellmotor zur Positionierung der jeweiligen Leiterplatte in Längs, Quer- sowie Drehrichtung dienen.

2. Vorrichtung nach Anspruch 1, dadurch gekennzeichnet, daß zwei Verstellmotoren parallele Spindeln je für sich in Längsrichtung betätigen und ein dritter Verstellmotor die beiden Verstellmotoren gemeinsam in Querrichtung verschiebt.

Fig. 1

Fig. 1a

**Fig.2**

Fig. 3

Fig 4